# EUROPÄISCHE PATENTSCHRIFT

(11) **EP 1 171 953 B1**
(45) Veröffentlichungstag und Bekanntmachung des Hinweises auf die Patenterteilung: **20.10.2004**
(21) Anmeldenummer: 00922596.2
(22) Anmeldetag: 01.04.2000
(51) Int. Cl.: H03K 17/965, F16P 3/10

(54) **VORRICHTUNG ZUM SCHALTEN EINER VERBINDUNG IN ABHÄNGIGKEIT DES ZUSTANDES EINER ZU ÜBERWACHENDEN EINRICHTUNG, INSBESONDERE SICHERHEITSSCHALTER**
DEVICE FOR SWITCHING A CONNECTION ACCORDING TO THE STATE OF A DEVICE TO BE MONITORED, ESPECIALLY A SAFETY SWITCH
DISPOSITIF POUR COMMUTER UNE CONNEXION EN FONCTION DE L'ETAT D'UN DISPOSITIF A SURVEILLER, NOTAMMENT UN INTERRUPTEUR DE SECURITE

(30) Priorität: 16.04.1999 DE 19917212
(43) Veröffentlichungstag der Anmeldung: 16.01.2002
(73) Patentinhaber: EUCHNER GmbH + Co. KG, 70771 Leinfelden-Echterdingen (DE)
(72) Erfinder: SAXER, Stefan, D-7320 Sargans (CH)
(74) Vertreter: Crazzolara, Helmut, Dr.
(86) Internationale Anmeldenummer: PCT/EP2000/002934
(87) Internationale Veröffentlichungsnummer: WO 2000/064054

(56) Entgegenhaltungen:
- EP-A- 0 781 630
- EP-A- 0 814 490
- EP-A- 0 870 653
- DE-A- 19 536 515
- DE-A- 19 711 588

## Beschreibung

Die vorliegende Erfindung betrifft eine Vorrichtung zum Schalten einer vorzugsweise elektrischen Verbindung in Abhängigkeit des Zustandes einer zu überwachenden Einrichtung, nämlich einen Sicherheitsschalter, gemäß dem Oberbegriff des Anspruchs 1.

Die DE 196 24 172 A1 zeigt einen Sicherheitsschalter mit einem durch seine Geometrie mechanisch codierten Betätiger, der beim Einführen in ein Schaltergehäuse eine Schaltwalze dreht und darüber hinaus einen Transponder aufweist, der im vollständig eingeführten Zustand des Betätigers von einem in dem Schaltergehäuse angeordneten Schreib- und Lesegerät auslesbar ist.

Aus der EP 0 870 653 A1 ist ein Gurtschloß bekannt, bei dem die Stellung eines das Verriegelungselement der Gurtzunge gegen unbeabsichtigtes Selbst-Lösen sicherndes und an dem Verriegelungselement gleitend verschiebbaren Sicherungselements mit einer Hall-Sonde und einem Magneten detektierbar ist. Das Sicherungselement wird bei manuellen Betätigen der Entriegelungstaste des Gurtschlosses aus seiner sichernden Stellung verschoben.

Aus der DE 197 11 588 A1 sind Sicherheitsschalter mit einem ein erstes Signalmittel aufweisenden und vorzugsweise an der zu überwachenden Einrichtung festlegbaren Betätiger, der mit einer ein zweites Signalmittel aufweisenden Betätigeraufnahme zusammenführbar ist und in dieser lösbar gegen ein Zurückziehen sperrbar ist, bekannt, wobei zwischen dem ersten und dem zweiten Signalmittel kontaktlos ein Signalaustausch durchführbar ist. Bei den bekannten Sicherheitsschaltern ist der Betätiger durch einen axial verschiebbaren und eine Öffnung des Betätigers durchgreifenden Stößel in der zusammengeführten Position sperrbar. Die Sperrung oder Verriegelung kann sowohl federkraft- oder magnetkraftbetätigt sein. Dabei sind zwei Paare von jeweils zusammengehörenden Signalmitteln erforderlich, um erstens den zusammengeführten Zustand von Betätiger und Betätigeraufnahme und zweitens den sperrenden Zustand des Stößels zu erkennen.

Der Erfindung liegt das Problem zugrunde, eine gattungsgemäße Vorrichtung bereitzustellen, die einfach und kostengünstig herstellbar ist und dennoch eine dauerhaft sichere Zuhaltung und Überwachung gewährleistet.

Das Problem ist durch die im Anspruch 1 bestimmte Vorrichtung gelöst. Besondere Ausführungsarten der Erfindung sind in den Unteransprüchen bestimmt.

Durch die erfindungsgemäße Lösung nach Anspruch 1 ist nur noch ein Paar von zusammengehörenden Signalmitteln erforderlich. Wenn ein Signalaustausch zwischen diesen beiden Signalmitteln möglich ist, ist gewährleistet, daß der Betätiger und die Betätigeraufnahme zusammengeführt sind und in dieser Position gesperrt sind, was gleichbedeutend damit ist, daß die zu überwachende Einrichtung, beispielsweise eine Sicherheitseinrichtung wie eine Schutzhaube oder ein Schutzgitter an einer Werkzeugmaschine, geschlossen und im geschlossenen Zustand gesichert ist (closed & locked). Beim Zusammenführen kommt es zwangsgeführt zu einem Eingriff von Betätiger und Betätigeraufnahme miteinander und damit zur Einnahme der Position des sperrenden Eingriffs. Die Signalmittel sind dabei am Betätiger und an der Betätigeraufnahme derart angeordnet, daß nur in der Position des sperrenden Eingriffs ein Signalaustausch möglich ist.
Die zusammengehörenden Signalmittel können auf verschiedenste Weise ausgestaltet sein. Beispielsweise kann nur eines der beiden Signalmittel ein Signal oder eine Information aussenden, und das andere Signalmittel dient im wesentlichen einer vollständigen oder teilweisen Reflexion des ausgesandten Signals, beispielsweise einer Licht- oder Ultraschallstrahlung. Alternativ kann das andere Signalmittel das ausgesandte Signal empfangen und unverändert oder individuell verändert zum einen Signalmittel zurücksenden. Dabei sind in eine oder beide Richtungen analoge und/oder digitale Signale übertragbar. Vorzugsweise stellt eines der Signalmittel auch die Energie für den Betrieb des anderen Signalmittels in Form von elektromagnetischer Strahlung im sichtbaren oder unsichtbaren Wellenlängenbereich zur Verfügung. Der Signalaustausch ist insofern kontaktlos durchführbar, weil die Signale nicht über elektrische Kontakte ausgetauscht werden, sondern drahtlos. Dadurch, daß der Betätiger durch das Zusammenführen zwangsläufig in sperrenden Eingriff mit der Betätigeraufnahme ist, kann ein den Betätiger sperrender Stößel entfallen.

Dadurch, daß der Betätiger und die Betätigeraufnahme zusammenwirkende Sperrflächen aufweisen, die beim Zusammenführen in sperrenden Eingriff miteinander gebracht werden und ein Zurückziehen des Betätigers von der Betätigeraufnahme sperren, ist eine Selbsthemmung realisiert, das heißt der Betätiger ist gehemmt, sich beispielsweise aufgrund von Vibrationen von der Betätigeraufnahme wegzubewegen. Die Sperrflächen können in Bezug auf die Einführrichtung des Betätigers derart ausgestaltet und/oder ausgerichtet sein, daß sich die Sperrkräfte beim Ziehen am Betätiger erhöhen. Der Betätiger kann zusätzlich durch einen Kraftspeicher oder einen Elektromagneten in der Position des sperrenden Eingriffs gehalten werden.

Dadurch, daß die Sperrflächen mit der Bewegungsrichtung des Betätigers beim Zusammenführen einen Winkel von 0 bis 90° einschließen, insbesondere von 60 bis 90°, ist die Selbsthemmung verstärkt und die Sperrkräfte beim Ziehen am Betätiger sind erhöht. Vorzugsweise sind die Sperrflächen derart ausgestaltet, daß sie sich ineinander verhaken.

Dadurch, daß die ersten und zweiten Signalmittel an den jeweiligen Sperrflächen angeordnet sind und insbesondere in der Position des sperrenden Eingriffs einander gegenüberliegen, ist mit besonders einfachen Mitteln gewährleistet, daß der Signalaustausch zwischen Betätiger und Betätigeraufnahme nur in der Position des sperrenden Eingriffs von Betätiger und Betätigeraufnahme möglich ist. Die Fehlschließsicherung, das heißt die Sicherung gegen einen Signalaustausch, obwohl der Betätiger noch nicht gesperrt ist, ist dabei zusätzlich erhöht.

Dadurch, daß die ersten und/oder zweiten Signalmittel eine Richtungscharakteristik mit mindestens einer bevorzugten Raumrichtung für den Signalaustausch aufweisen, ist die Fehlschließsicherung weiter erhöht, da ein Signalaustausch nicht bereits beim Annähern der beiden Signalmittel möglich ist, sondern erst dann, wenn die Position des sperrenden Eingriffs eingenommen ist und die beiden Signalmittel unmittelbar benachbart sind, insbesondere gegenüberliegend sind.

Dadurch, daß der Betätiger schwenkbar ist, insbesondere schwenkbar an der zu überwachenden Einrichtung festgelegt ist, ist er besonders einfach in sperrenden Eingriff mit der in der Regel feststehenden Betätigeraufnahme zu bringen. Der Betätiger ist dabei vorzugsweise um eine Achse schwenkbar, die mit der Einführrichtung einen rechten Winkel einschließt oder mit dieser zusammenfällt. Der Betätiger verfügt in der Regel über keine eigene Energieversorgung, das heißt das an ihm angebrachte Signalmittel erhält seine Energie, sofern dies erforderlich ist, aus dem vom zweiten Signalmittel aufgebauten elektromagnetischen Feld. Selbstverständlich kann zusätzlich oder alternativ der Betätiger auch verschiebbar sein, ebenso wie auch die Betätigeraufnahme schwenkbar und/oder verschiebbar sein kann.

Dadurch, daß der Betätiger beim Zusammenführen mit der Betätigeraufnahme aufgrund seiner Gewichtskraft die Position des sperrenden Eingriffs einnimmt, ist keine zusätzliche Kraftquelle für das Sperren des Betätigers erforderlich. Sofern eine Sperrung in jeder Montageposition wünschenswert oder erforderlich ist, kann zusätzlich oder alternativ eine federkraft- oder magnetkraftbetätigte Sperrung vorgesehen sein.

Dadurch, daß der Signalaustausch elektromagnetisch erfolgt, ist die Sicherheit und Zuverlässigkeit der Vorrichtung weiter erhöht.
Der Signalaustausch kann dabei beispielsweise über elektromagnetische oder (Ultra)Schallwellen erfolgen. Im Falle von elektromagnetischen Wellen kommt sowohl ein Signalaustausch mittels Radiowellen als auch mittels optischer Strahlung in Frage. In beiden Fällen ist auch eine Energieübertragung möglich. Mit Standardbauelementen und dadurch kostengünstig läßt sich insbesondere ein Signalaustausch auf der Grundlage von Radiowellen bereitstellen, wobei das eine Signalmittel eine Anfrage aussendet, die vom anderen Signalmittel empfangen wird und unverändert oder gegebenenfalls individuell verändert an das erste Signalmittel zurückgesandt wird. Dadurch ist beispielsweise eine Erkennung und Identifikation des Betätigers möglich.

Dadurch, daß das Lösen des sperrenden Eingriffs aufgrund einer elektromagnetischen Kraft oder mittels einer Druckluftbeaufschlagung erfolgt, kann das Öffnen beispielsweise einer Schutzhaube für eine Werkzeugmaschine von der Steuerung für die Werkzeugmaschine gesteuert sein. Alternativ oder ergänzend kommt auch ein Lösen mittels eines Zuges, beispielsweise eines Bowdenzuges, in Betracht. Der Betätiger und die Betätigeraufnahme können dabei so ausgestaltet sein, daß ein einmaliger Löseimpuls zu einem Herausbewegen aus der Position des sperrenden Eingriffs und damit zu einem Entsperren führt, der ein anschließendes und gegebenenfalls zeitversetztes Öffnen bzw. Herausziehen des Betätigers ermöglicht.

Weitere Vorteile, Merkmale und Einzelheiten der Erfindung ergeben sich aus den Unteransprüchen sowie der nachfolgenden Beschreibung, in der unter Bezugnahme auf die Zeichnungen mehrere Ausführungsbeispiele im einzelnen beschrieben sind. Dabei können die in den Ansprüchen und in der Beschreibung erwähnten Merkmale jeweils einzeln für sich oder in beliebiger Kombination erfindungswesentlich sein.
- Fig. 1: zeigt eine erfindungsgemäße Vorrichtung vor dem Zusammenführen des Betätigers mit der Betätigeraufnahme,
- Fig. 2: zeigt die erfindungsgemäße Vorrichtung in der Position des sperrenden Eingriffs von Betätiger und Betätigeraufnahme,
- Fig. 3: zeigt eine zweite Ausführungsform der Erfindung,
- Fig. 4: zeigt eine dritte Ausführungsform der Erfindung in der Position des sperrende Eingriffs, und
- Fig. 5: zeigt die Vorrichtung der Fig. 4 in der den sperrenden Eingriff gelösten Position.

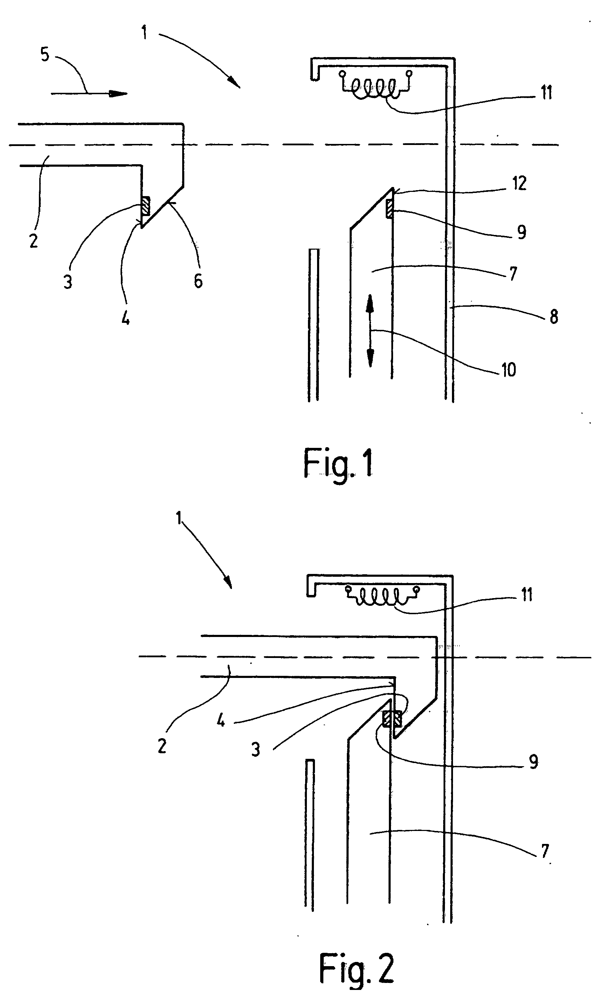

Die Fig. 1 zeigt eine erfindungsgemäße Vorrichtung 1 vor dem Zusammenführen des Betätigers 2 mit der Betätigeraufnahme 7.
Die Vorrichtung 1 ist nur schematisch und insbesondere nicht maßstabsgetreu dargestellt. Die zu überwachende Einrichtung ist aus Gründen der Übersichtlichkeit nicht dargestellt. Der Betätiger 2 weist ein erstes Signalmittel 3 auf, bei dem es sich beispielsweise um einen sogenannten Transponder-Baustein handelt. Dieses ist an einer Sperrfläche 4 angeordnet, die mit der Bewegungsrichtung 5 des Betätigers 2 beim Zusammenführen im wesentlichen einen rechten Winkel einschließt.
Der Betätiger 2 weist eine Einführschräge 6 auf, die mit der Richtung 5 einen Winkel zwischen 0 und 90° einschließt, im vorliegenden Ausführungsbeispiel 45°. Der Betätiger 2 ist um eine senkrecht zur Zeichenebene der Fig. 1 stehende Achse schwenkbar und/oder in einer mit der Richtung 5 einen rechten Winkel einschließenden Richtung verschiebbar.

Die Betätigeraufnahme 7 ist innerhalb eines Gehäuses 8 angeordnet, das im wesentlichen zum Schutz gegen Manipulation der Vorrichtung 1 dient. Die Betätigeraufnahme 7 weist ein zweites Signalmittel 9 auf und kann zusätzlich und/oder alternativ zur Beweglichkeit des Betätigers 2 unter der Wirkung einer Kraftquelle oder eines Kraftspeichers in Richtung des Doppelpfeils 10 verschiebbar ausgeführt sein. Eine im Gehäuse 8 angeordnete und schematisch dargestellte Magnetspule 11 dient einem Anheben und/oder Verschwenken des mit der Betätigeraufnahme 7 zusammengeführten Betätigers 2 zum Lösen der Sperrung.
Die Betätigeraufnahme 7 bildet eine zweite Sperrfläche 12 aus, die mit der Richtung 5 des Betätigers im wesentlichen einen rechten Winkel einschließt.

Die Fig. 2 zeigt die erfindungsgemäße Vorrichtung in der Position des sperrenden Eingriffs von Betätiger 2 und Betätigeraufnahme 7. Dabei sind das erste Signalmittel 3 des Betätigers 2 und das zweite Signalmittel 9 der Betätigeraufnahme 7 unmittelbar benachbart und insbesondere einander gegenüberliegend. Die erste Sperrfläche 4 des Betätigers 2 liegt dabei der zweiten Sperrfläche 12 der Betätigeraufnahme 7 gegenüber und bei einer Zugbeanspruchung des Betätigers 2 entgegen der Richtung 5 kommen die beiden Sperrflächen 4, 12 in Anlage und sperren die weitere Bewegung des Betätigers 2. Vorteilhaft bei dieser Ausführungsart ist, daß die beiden Signalmittel 3, 9 erst dann unmittelbar benachbart sind, wenn der Betätiger 2 in der Position des sperrenden Eingriffs mit der Betätigeraufnahme 7 ist. Ein Signalaustausch ist demnach erst dann möglich, wenn die Position des sperrenden Eingriffs sicher eingenommen worden ist. Zum Lösen der Position des sperrenden Eingriffs ist beispielsweise ein Stromimpuls auf die Magnetspule 11 und ein Herausziehen des Betätigers entgegen der Richtung 5 erforderlich.

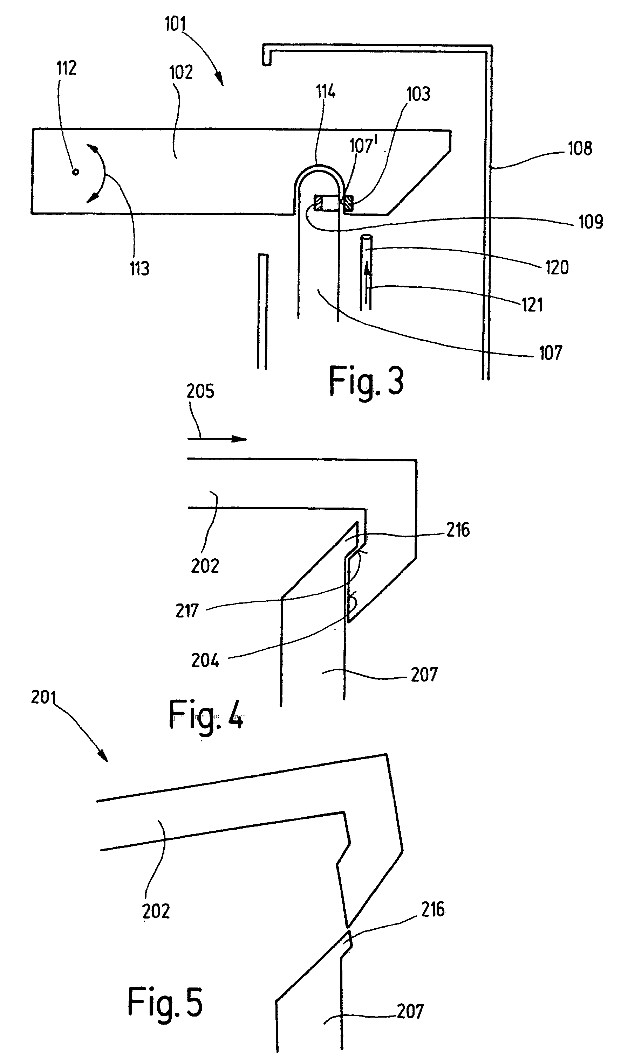

Die Fig. 3 zeigt eine zweite Ausführungsform 101 der Erfindung.
Der Betätiger 102 ist um die Achse 112 in Richtung des Doppelpfeils 113 schwenkbar angelenkt. Der Betätiger 102 weist eine sacklochförmige oder schlitzförmige Aufnahme 114 für die Betätigeraufnahme 107 auf.
Die Aufnahme 114 und die Betätigeraufnahme 107 sind an ihrem jeweiligen Endabschnitt halbkugelförmig und/oder im Querschnitt halbkreisförmig ausgebildet. Das erste Signalmittel 103 im Betätiger 102 ist in der dargestellten Position des sperrenden Eingriffs gegenüber dem zweiten Signalmittel 109 der Betätigeraufnahme 107 angeordnet.
Das zweite Signalmittel 109 ist dabei von der dem ersten Signalmittel 103 zugekehrten Wandung 107' zurückversetzt, um in Zusammenwirkung mit dem zumindest in diesem Bereich metallischen Betätiger 102 eine Richtungscharakteristik der Signalstrahlung zu erzielen, die die Fehlschließsicherung der Vorrichtung 101 weiter erhöht. Das Lösen aus der Position des sperrenden Eingriffs erfolgt in diesem Ausführungsbeispiel mittels Druckluftbeaufschlagung über die Düse 120 in Richtung des Pfeils 121. Die aus der Düse 120 austretende Druckluft schwenkt den Betätiger 102 um die Achse 112 so weit, daß das Zurückziehen des Betätigers 102 nicht mehr durch die Betätigeraufnahme 107 gesperrt ist.

Die Fig. 4 zeigt eine dritte Ausführungsform 201 der Erfindung in der Position des sperrende Eingriffs. Die Betätigeraufnahme 207 bildet dabei einen Rastzahn 216 aus, der die erste Sperrfläche 204 des Betätigers 202 hintergreift. Der Betätiger 202 bildet hierzu eine schräge Schulterfläche 217 aus, die mit der Richtung 205 einen Winkel zwischen 0 und 90° einschließt, im vorliegenden Ausführungsbeispiel von 45°. Diese Ausgestaltung hat den Vorteil, daß beim Ziehen am Betätiger 202 entgegen der Richtung 205 die Sperrwirkung erhöht ist.

Die Fig. 5 zeigt die Vorrichtung der Fig. 4 in der den sperrenden Eingriff gelösten Position. Durch einen kurzen mechanischen, magnetischen und/oder Druckluft-Impuls ist der Betätiger 202 um die außerhalb des dargestellten Bereichs angeordnete Schwenkachse verdreht worden und bleibt nach Ende des Impulses auf dem Rastzahn 216 der Betätigeraufnahme 207 liegen, so daß der Betätiger 202 nicht wieder die Position des sperrenden Eingriffs einnimmt und auch mit einer gewissen Zeitverzögerung aus der Vorrichtung herausziehbar ist.

## Patentansprüche

1. Vorrichtung (1; 101; 201) zum Schalten einer Verbindung in Abhängigkeit des Zustandes einer zu überwachenden Einrichtung, nämlich Sicherheitsschalter, mit einem ein erstes Signalmittel (3; 103) aufweisenden Betätiger (2; 102; 202), der mit einer ein zweites Signalmittel (9; 109) aufweisenden Betätigeraufnahme (7; 107; 207) zusammenführbar ist und lösbar gegen ein Zurückziehen sperrbar ist, wobei zwischen dem ersten (3; 103) und dem zweiten (9; 109) Signalmittel kontaktlos ein Signalaustausch durchführbar ist, **dadurch gekennzeichnet, daß** der Betätiger (2; 102; 202) und die das zweite Signalmittel (9; 109) aufweisende Betätigeraufnahme (7; 107; 207) im zusammengeführten Zustand in sperrendem Eingriff miteinander sind, und daß das erste (3; 103) und zweite (9; 109) Signalmittel derart angeordnet sind, daß der Signalaustausch zwischen Betätiger (2; 102; 202) und Betätigeraufnahme (7; 107; 207) nur in der Position des sperrenden Eingriffs möglich ist.

2. Vorrichtung (1; 101; 201) nach Anspruch 1, **dadurch gekennzeichnet, daß** der Betätiger (2; 102; 202) und die Betätigeraufnahme (7; 107; 207) zusammenwirkende Sperrflächen (4, 12) aufweisen, die beim Zusammenführen in Eingriff miteinander gebracht werden und ein Zurückziehen des Betätigers (2; 102; 202) von der Betätigeraufnahme (7; 107; 207) sperren.

3. Vorrichtung (1; 101; 201) nach Anspruch 2, **dadurch gekennzeichnet, daß** die Sperrflächen (4, 12) mit der Bewegungsrichtung (5) des Betätigers (2; 102; 202) beim Zusammenführen einen Winkel von 0 bis 90° einschließen, insbesondere von 60 bis 90°.

4. Vorrichtung (1; 101; 201) nach Anspruch 2 oder 3, **dadurch gekennzeichnet, daß** die ersten (3; 103) und zweiten (9; 109) Signalmittel an den jeweiligen Sperrflächen (4; 12) angeordnet sind

5. Vorrichtung (1; 101; 201) nach Anspruch 4, **dadurch gekennzeichnet, daß** die Signalmittel in der Position des sperrenden Eingriffs einander gegenüberliegen.

6. Vorrichtung (1; 101; 201) nach einem der Ansprüche 1 bis 5, **dadurch gekennzeichnet, daß** die ersten (3; 103) und/oder zweiten (9; 109) Signalmittel eine Richtungscharakteristik mit mindestens einer bevorzugten Raumrichtung für den Signalaustausch aufweisen.

7. Vorrichtung (1; 101; 201) nach einem der Ansprüche 1 bis 6, **dadurch gekennzeichnet, daß** der Betätiger (2; 102; 202) schwenkbar ist.

8. Vorrichtung (1; 101; 201) nach einem der Ansprüche 1 bis 7, **dadurch gekennzeichnet, daß** der Betätiger (2; 102; 202) beim Zusammenführen mit der Betätigeraufnahme (7; 107; 207) aufgrund seiner Gewichtskraft die Position des sperrenden Eingriffs einnimmt.

9. Vorrichtung (1; 101; 201) nach einem der Ansprüche 1 bis 8, **dadurch gekennzeichnet, daß** der Signalaustausch elektromagnetisch erfolgt.

10. Vorrichtung (1; 101; 201) nach einem der Ansprüche 1 bis 9, **dadurch gekennzeichnet, daß** das Lösen des sperrenden Eingriffs aufgrund einer elektromagnetischen Kraft oder mittels einer Druckluftbeaufschlagung erfolgt.

11. Vorrichtung (1; 101; 201) nach einem der Ansprüche 1 bis 10, **dadurch gekennzeichnet, daß** der Betätiger (2; 102; 202) an der zu überwachenden Einrichtung festlegbar ist.

## Claims

1. Device (1; 101; 201) for switching a connection in accordance with the state of a device to be monitored, that is to say, a safety switch, having an actuator (2; 102; 202) which has a first signalling means (3; 103) and which can be joined together with an actuator receiving element (7; 107; 207) having a second signalling means (9; 109), and which can be releasably locked against being withdrawn, a signal exchange being able to be carried out in a contact-less manner between the first signalling means (3; 103) and the second signalling means (9; 109), **characterised in that** the actuator (2; 102; 202) and the actuator receiving element (7; 107; 207) having the second signalling means (9; 109) are in locking engagement with each other in the joined-together state, and **in that** the first signalling means (3; 103) and the second signalling means (9; 109) are arranged in such a manner that the signal exchange between the actuator (2; 102; 202) and the actuator receiving element (7; 107; 207) is possible only in the position of locking engagement.

2. Device (1; 101; 201) according to claim 1, **characterised in that** the actuator (2; 102; 202) and the actuator receiving element (7; 107; 207) have co-operating locking faces (4, 12) which are brought into engagement with each other during the joining operation and which lock the actuator (2; 102; 202) against being withdrawn from the actuator receiving element (7; 107; 207).

3. Device (1; 101; 201) according to claim 2, **characterised in that** the locking faces (4, 12) enclose an angle of from 0 to 90°, in particular of from 60 to 90°, with the movement direction (5) of the actuator (2; 102; 202) during the joining operation.

4. Device (1; 101; 201) according to claim 2 or 3, **characterised in that** the first signalling means (3; 103) and second signalling means (9; 109) are arranged on the respective locking faces (4; 12).

5. Device (1; 101; 201) according to claim 4, **characterised in that** the signalling means are located opposite each other in the position of locking engagement.

6. Device (1; 101; 201) according to any one of claims 1 to 5, **characterised in that** the first signalling means (3; 103) and/or the second signalling means (9; 109) have directional characteristics having at least one preferred spatial direction for the signal exchange.

7. Device (1; 101; 201) according to any one of claims 1 to 6, **characterised in that** the actuator (2; 102; 202) is pivotable.

8. Device (1; 101; 201) according to any one of claims 1 to 7, **characterised in that** the actuator (2; 102; 202) assumes the position of locking engagement when it is joined together with the actuator receiving element (7; 107; 207) owing to the force of the weight thereof.

9. Device (1; 101; 201) according to any one of claims 1 to 8, **characterised in that** the signal exchange is carried out in an electromagnetic manner.

10. Device (1; 101; 201) according to any one of claims 1 to 9, **characterised in that** the locking engagement is released owing to an electromagnetic force or by means of an application of compressed air.

11. Device (1; 101; 201) according to any one of claims 1 to 10, **characterised in that** the actuator (2; 102; 202) can be fixed to the device to be monitored.

## Revendications

1. Dispositif (1 ; 101 ; 201) destiné à établir une liaison en fonction de l'état d'un dispositif à surveiller, à savoir un commutateur de sécurité, comprenant un actionneur (2 ; 102 ; 202) muni d'un premier moyen de signalisation (3 ; 103) qui peut être amené en jonction avec un positionneur (7 ; 107 ; 207), muni d'un deuxième moyen de signalisation (9 ; 109), et peut être bloqué de manière amovible et en empêchant un retrait, un échange de signaux pouvant être effectué sans contact entre le premier (3 ; 103) et le deuxième moyen de signalisation (9 ; 109), **caractérisé en ce que** l'actionneur (2 ; 102 ; 202) et le positionneur (7 ; 107 ; 207) muni du deuxième moyen de signalisation (9 ; 109) sont en prise bloquée l'un avec l'autre dans la position de jonction, et **en ce que** le premier (3 ; 103) et le deuxième moyen de signalisation (9 ; 109) sont agencés de telle sorte que l'échange de signaux entre l'actionneur (2 ; 102 ; 202) et le positionneur (7 ; 107 ; 207) n'est possible que dans la position de prise bloquée.

2. Dispositif (1 ; 101 ; 201) selon la revendication 1, **caractérisé en ce que** l'actionneur (2 ; 102 ; 202) et le positionneur (7 ; 107 ; 207) ont des surfaces de blocage (4, 12), qui coopèrent entre elles et qui sont amenées en prise l'une avec l'autre au moment de la jonction et empêchent le retrait de l'actionneur (2 ; 102 ; 202) à partir du positionneur (7 ; 107 ; 207).

3. Dispositif (1 ; 101 ; 201) selon la revendication 2, **caractérisé en ce que** les surfaces de blocage (4, 12), au moment de la jonction, forment avec la direction de déplacement (5) de l'actionneur (2 ; 102 ; 202) un angle de 0 à 90°, en particulier de 60 à 90°.

4. Dispositif (1 ; 101 ; 201) selon la revendication 2 ou 3, **caractérisé en ce que** le premier (3 ; 103) et le deuxième moyen de signalisation (9 ; 109) sont agencés contre les surfaces de blocage (4 ; 12) respectives.

5. Dispositif (1 ; 101 ; 201) selon la revendication 4, **caractérisé en ce que**, dans la position de prise bloquée, les moyens de signalisation sont disposés en regard l'un de l'autre.

6. Dispositif (1 ; 101 ; 201) selon l'une quelconque des revendications 1 à 5, **caractérisé en ce que** le premier (3 ; 103) et/ou le deuxième moyen de signalisation (9 ; 109) ont une caractéristique directionnelle avec au moins une direction dans l'espace préférée pour l'échange de signaux.

7. Dispositif (1 ; 101 ; 201) selon l'une quelconque des revendications 1 à 6, **caractérisé en ce que** l'actionneur (2 ; 102 ; 202) est pivotant.

8. Dispositif (1 ; 101 ; 201) selon l'une quelconque des revendications 1 à 7, **caractérisé en ce que** l'actionneur (2 ; 102 ; 202), au moment de la jonction avec le positionneur (7 ; 107 ; 207), entre dans la position de prise bloquée sous l'effet de son poids.

9. Dispositif (1 ; 101 ; 201) selon l'une quelconque des revendications 1 à 8, **caractérisé en ce que** l'échange de signaux s'effectue par voie électromagnétique.

10. Dispositif (1 ; 101 ; 201) selon l'une quelconque des revendications 1 à 9, **caractérisé en ce que** la prise bloquée est désolidarisée sous l'effet d'une force électromagnétique ou au moyen d'une sollicitation par air comprimé.

11. Dispositif (1 ; 101 ; 201) selon l'une quelconque des revendications 1 à 10, **caractérisé en ce que** l'actionneur (2 ; 102 ; 202) peut être fixé contre le dispositif à surveiller.
